Europäisches Patentamt

European Patent Office

Office européen des brevets

(11) Veröffentlichungsnummer: **0 191 137**
**A2**

(12) # EUROPÄISCHE PATENTANMELDUNG

(21) Anmeldenummer: 85111848.9

(22) Anmeldetag: 19.09.85

(51) Int. Cl.4: **G01B 7/02** , G01B 7/14 , H03K 17/955

Die Bezeichnung der Erfindung wurde geändert (Richtlinien für die Prüfung im EPA, A-III, 7.3).

(30) Priorität: 22.09.84 DE 3434940

(43) Veröffentlichungstag der Anmeldung:
20.08.86 Patentblatt 86/34

(84) Benannte Vertragsstaaten:
AT BE CH FR GB IT LI LU NL SE

(71) Anmelder: **Jores, Heinrich**
**Europaring 78**
**D-6090 Rüsselsheim 7(DE)**

(72) Erfinder: **Jores, Heinrich**
**Europaring 78**
**D-6090 Rüsselsheim 7(DE)**

(54) **Kapazitiver Annäherungssensor hoher Ansprechempfindlichkeit.**

(57) 4.

### Zusammenfassung der Erfindung

Der der Erfindung zugrunde liegende kapazitive Annäherungssensor hoher Ansprechempfindlichkeit ist einsetzbar als Annäherungsschalter oder als Meßwertgeber für Meß- und Regelzwecke.

Er ist ein vollständiger Ersatz für kapazitive Annäherungsschalter nach dem herkömmlichen Prinzip und zusätzlich zur Übernahme von Aufgaben geeignet, die bisher vorwiegend mit induktiven Annäherungsschaltern gelöst wurden.

Sein bevorzugter Einsatzbereich ist jedoch:

- bei gefordertem großen Nennabstand (möglicher Schaltabstand des Versuchsaufbaus > 300 mm)

- bei geforderter geringer Schalthysterese (Schalthysterese des Versuchsaufbaus 15 mm bei 300 mm Schaltabstand, das entspricht 5% des Nennabstandes)

- bei gefordertem einwandfreien Arbeiten auch bei störenden Umwelteinflüssen (Temperaturschwankungen, Störspannungen beim Schalten von Schützen, Luftfeuchtigkeit usw.)

Er findet Anwendung bei:

- Melde- und Anzeigevorrichtungen

- Sicherungs- und Überwachungsaufgaben

- Schutz- und Sicherheitsmaßnahmen

- Überprüfungs- und Kontrollfunktionen

- Schalt-, Meß- und Regelvorgängen

- Rationalisierungs- und Automatisierungsverfahren

Kapazitiver Annäherungssensor hoher Ansprechempfindlichkeit zur Schaltsignalabgabe bei Anwesenheit eines Objekts Innerhalb seines einstellbaren Nennabstandbereichs und zur Messung bzw. Regelung des Sensor-Objektabstands bei vorgegebenem Nennabstand als Bezugsgröße

## 1. Beschreibung der Erfindung

### 1.1 Aufgabe, Einsatzbereich, Vorteile und augenblicklicher technischer Stand der kapazitiven Annäherungssensoren

#### 1.1.1 Vorteile der Annäherungssensoren gegenüber herkömmlichen Befehlsgebern

Herkömmliche Befehlsgeber sind Endschalter, Grenztaster, Positionsschalter usw. Sie arbeiten aufgrund mechanischer Abtastung. Ihre Abtastorgane sind Hebel, Rollen und Stößel, deren Anfahrweg, Anfahrwinkel und Nachlauf berechnet werden muß. Zu ihrer Betätigung ist Schaltkraft erforderlich. Der Schaltzustand wird über Kontakte, deren Lebensdauer begrenzt ist, nach außen geführt. Da mechanische Teile dem Verschleiß unterliegen, ist ständige Wartung erforderlich.

Diese Nachteile und Schwierigkeiten bestehen bei kapazitiven Annäherungssensoren mit kontaktlosem Ausgang nicht. Sie arbeiten ohne mechanische Abtastorgane, eine Schaltkraft ist nicht erforderlich. Der Eintritt eines Objekts in ihre aktive Wahrnehmungszone wird hier in ein Schaltsignal umgesetzt, das kontaktlos nach außen geführt werden kann. Damit wird die Lebensdauer der kapazitiven Annäherungssensoren durch die Schalthäufigkeit nicht begrenzt (keine mechanisch bewegten Teile, kein Verschleiß), eine Wartung ist nicht erforderlich.

#### 1.1.2 Aufgabe und Wirkungsweise eines kapazitiven Annäherungssensors

Die Aufgabe eines kapazitiven Annäherungssensors ist die Wahrnehmung eines in seiner Nähe befindlichen Objekts und die Umsetzung dieser Wahrnehmung in ein elektrisches Signal. Die Wahrnehmung des Objekts erfolgt über die aktive Wahrnehmungszone des Sensors, ein elektromagnetisches Wechselfeld. Durch An- bzw. Abwesenheit eines genügend großen Objekts innerhalb dieses Feldes wird das Ausgangssignal des Annäherungssensors beeinflußt. Gegenüber induktiven Annäherungssensoren, die nur auf Metalle ansprechen, können bei kapazitiven Annäherungssensoren auch Gegenstände aus Holz, Stein oder Flüssigkeiten, wie Wasser, Getränke, aggressive chemische Flüssigkeiten usw., berührungslos abgetastet und erfaßt werden, was den Einsatzbereich dieser Sensorart erheblich vergrößert.

#### 1.1.3 Augenblicklischer technischer Stand der kapazitiven Annäherungssensoren

Da Annäherungssensoren als vorgeschobene Fühler von Steuerungen (berührungslose Endschalter, Grenztaster, Positionsschalter usw.), von Meßgeräten (Zähler, Impulsgeber, Distanzmesser, Füllstandsanzeiger usw.) und Reglern - (Abstandregler, Niveauregler usw.) dienen, müssen sie auch bei störenden Umwelteinflüssen und -bedingungen einwandfrei arbeiten und den jeweils vorliegenden Betriebszustand zuverlässig anzeigen.

Annäherungssensoren, in Form kapazitiver Annäherungsschalter nach dem herkömmlichen Prinzip, werden von einer Vielzahl von Firmen hergestellt. Der Marktanteil der kapazitiven Annäherungsschalter ist jedoch gegenüber den induktiven als gering zu bezeichnen. Diese Tatsache beruht zum Teil auf der höheren Störanfälligkeit der kapazitiven gegenüber den induktiven Annäherungsschaltern. Die größten Nennabstände kapazitiver Annäherungsschalter bekannter Fabrikate sind in folgender Tabelle zusammengestellt:

| Herstellerfirma | Typ | Schaltabstand |
|---|---|---|
| Baumer-electric<br>CH 8500 Frauenfeld | CFRK 34 L/D⌐ | 2o mm |
| Carlo Gavazzi Omron<br>CH 8o26 Zürich | E2K-C25M.. | 25 mm |
| ifm-electronic<br>D 43oo Essen 1 | KD-2o5o/3o5o.... | 5o mm |
| Lehner<br>D 783o Emmendingen 14 | KS 4o31 | 4o mm |
| Rechner Industrie-Elektronik<br>D 684o Lampertheim | KAS 7o/8o-61-S/Ö | 6o mm |
| K.A. Schmersal<br>D 56oo Wuppertal 2 | IFC 35-384-1oy.. | 35 mm |
| Siemens<br>Berlin - München | 3SG3135-ONR 41/42 | 2o, mm |
| Telemecanique Electrique<br>D 4o3o Ratingen | XTA-A2o9115/16 | 2o mm |

### 1.1.4 Bevorzugter Einsatzbereich des neuen Sensors Der der hier beschriebenen Erfindung zugrunde liegende kapazitive Annäherungssensor, im weiteren Verlauf der Beschreibung kurz, neuer Sensor' genannt, zeichnet sich bei seinem Einsatz als kapazitiver Annäherungsschalter gegenüber Fabrikaten herkömmlicher Bauart durch seine hohe Ansprechempfindlichkeit aus. Sein bevorzugter Einsatzbereich ist damit gegeben:

- beim Abtasten von Gegenständen aus Glas, Kunststoff, Papier, Geweben, Folien und von nicht leitenden Flüssigkeiten, Benzin, Öl usw.

- bei gefordertem großen Schaltabstand (mögliche Schaltabstände des Versuchsaufbaus bei Handannäherung größer 300 mm)

- bei geforderter geringer Schalthysterese (15 mm bei 300 mm Schaltabstand = 5%)

- bei gefordertem einwandtfreien Arbeiten auch bei störenden Umwelteinflüssen und -bedingungen - (Temperaturschwankungen, Störspannungen beim Schalten von Schützen usw.)

Er findet Anwendung bei Schaltvorgängen als

- Endschalter

- Positionsschalter

- Statischer Annäherungsschalter

- Dynamischer Annäherungsschalter

- Grenztaster

- Schalter für Flüssigkeiten und feste Gegenstände durch Trennwände aus Gals, Kunststoff, Holz, Papier usw. hindurch

- abgekapselter Schalter für aggressive chemische Flüssigkeiten

bei Überprüfungs- und Kontrollfunktionen zur

- Füllstandskontrolle

- Drehzahlkontrolle

- Durchgangskontrolle von festen Stoffen

- Abrißkontrolle von Bändern und Bahnen

- Durchflußkontrolle von Flüssigkeiten

- Niveaukontrolle von Schüttgut

bei Melde- und Anzeigevorrichtungen zur

- Minimal- bzw. Maximalwertanzeige

- Grenzwertanzeige

- Niveau-bzw Füllstandsanzeige

- Störmeldung

- Fehlermeldung

bei Meßvorgängen als

- Distanzmesser

- Durchflußmengenmesser

bei Regelungsvorgängen zur

- Abstandsregelung

- Niveauregelung

- Durchgangsmengenregelung

bei Sicherungs- und Überwachungsaufgaben zur

- Türkantensicherung

- Diebstahlsicherung

- Distanzsicherung

bei Schuts- und Sicherheitsmaßnahmen als

- Anwesenheitsdetektor

- Drehzahlwächter

- Bewegungsmelder

bei Rationlisierungs- und Automatisierungsvorgängen zum

- Abfüllen

- Registrieren

- Zählen

- Sortieren

- Abtasten

1.2 Funktionsschema und Wikungsprinzip der Erfindung

Da eine Gleichspannungs- gegenüber einer Wechselspannungsverstärkung problematisch ist, wird beim Aufbau des hier beschriebenen neuen Sensors die von einem Sinusoszillator erzeugte Schwingkreiswechselspannung verwendet.

Der Wirkungsprinzipauswahl dieses Annäherungssensors werden folgende Überlegungen, anhand der Funktionsschemas und Prinzipschaltbilder 1, 2 und 3 näher erläutert, vorangestellt. Die hierbei verwendeten Kurzbezeichnungen haben folgende Bedeutung:

AV = Antennenverstärker

AS = Antennensystem

$C_{WM}$ = Antennenmassekapazität

LC = Parallelschwingkreis des Sinusoszillators

M = Masse

NT = Netzteil

R = Antennenwiderstand

S = Schwingkreisausgang

SG = Schaltgerät

SO = Sinusoszillator

$U_{CWM}$ = Spannungsabfall über Antennenmassekapazität $C_{WM}$

$U_R$ = Spannungsabfall über Antennenwiderstand R

$U_S$ = Schwingkreisausgangsspannung

$U_W$ = Antennenausgangsspannung

W = Antenne

1.2.1 Funktionsschema und Prinzipschaltbild 1

Entsprechend Funktionsschema 1 (siehe Bild 1) wird der auf Nullpotential Netzteil liegende Schwingkreisanschluß N des Sinusoszillators SO auf Masse M gelegt (geerdet) und die Schwingkreisausgangsspannung $U_S$ vom Schwingkreisausgang S über den Antennenwiderstand R der Antenne W zugeführt.

Für die Antennenmassekapazität (die Kapazität, die die Antenne W mit der sie umgebenden Masse M bildet und durch die die Antenne ohne Annäherung eines Objekts bereits vorbelastet wird) $C_{WM} = o$ (theoretischer Wert, praktisch nicht erreichbar) ist die Antennenausgangsspannung $U_W$, die dem Spannungsabfall über der Anten nenmassekapazität $C_{WM}$ entspricht,

$$U_W = U_{CWM}$$

$$= U_S$$

und für

$$C_{WM} > o$$

(mit den tatsächlichen Verhältnissen überreinstimmender Wert)

wird

$$U_W = U_{CWM}$$

$$< U_S$$

Dieses Prinzip, schaltungstechnisch in Prinzipschaltbild 1 umgesetzt (siehe Bild 2), ergibt, daß den auf das Antennensystem AS folgenden Funktionseinheiten - (Antennenverstärker AV und Schaltgerät SG) die Antennenausgangsspannung $U_W = U_{CWM} < U_S$ zugeführt wird.

1.2.2 Funktionsschema und Prinzipschaltbild 2

Für Schalt-, Meß- oder Regelungszwecke, je nach Einsatz des Annäherungssensors, kann als Antennenausgangsspannung $U_W$ nur die Wechselspannungsdifferenz zwischen Schwingkreisausgang S und Antenne W genutzt werden, die dem Spannungsabfall über dem Antennenwiderstand R entspricht:

$$U_W = U_R = U_S - U_{CWM}$$

Bei Nutzung dieser Spannungsdifferenz folgt aus dem diesem Fall entsprechenden Funktionsschema (siehe Bild 3), daß nicht das Netzteilnullpotential N, sondern der Schwingkreisausgang S als Bezugspunkt für die Antennenausgangsspannung

$$U_W = U_R$$

angenommen werden muß.

Dieses Prinzip, schaltungstechnisch in Prinzipschaltbild 2 umgesetzt (siehe Bild 4), ergibt, daß nur der Sinusoszillator SO über Netzteil NT1, alle übrigen Funktionseinheiten (Antennenverstärker AV und Schaltgerät SG) jedoch potentialmäßig über ein zweites Netzteil NT2 gespeist werden müssen.·

1.2.3. Funktionsschema und Prinzipschaltbild 3 Dieser zusätzliche Aufwand eines zweiten Netzteils NT2 kann vermieden werden, wenn entsprechend Funktionsschema 3 (siehe Bild 5) der Schwingkreisausgang S auf Masse M gelegt (geerdet) und die Schwingkreiswechselspannung $U_S$ über den Antennenwiderstand R, diesmal vom Nullpotential des Netzteiles NT aus, der Antenne W zugeführt wird. Dieses Prinzip, schaltungstechnisch in Prinzipschaltbild 3 (siehe Bild 6) umgesetzt, ergibt, daß alle Funktionseinheiten (Sinusoszillator SO, Antennenverstärker AV und Schaltgerät SG) potentialmäßig über ein Netzteil NT gespeist werden können.

1.2.4 Das dem neuen Sensor zugrunde gelegte Wirkungsprinzip Prinzipschaltbild 3 (siehe Bild 6) stellt, - schaltungstechnisch gesehen, die einfachste und damit zweckmäßigste Lösung dar. Sie wird dem hier beschriebenem Aufbau des neuen Sensors zugrunde gelegt. Bei dem nach diesem Prinzip aufgebauten Versuchsgerät wurden bei einer Schwingfrequenz des Sinusoszillators SO von 1o kHz sehr gute Ergebnisse bezüglich der Ansprechempfindlichkeit des Sensors erzielt, obgleich hier, wie bereits beschrieben, das Netzteil NT über dem Parallelschwingkreis des Sinusoszillators SO im Huckepackbetrieb arbeitet.

1.3 Die dem Aufbau des Antennensystems der Erfindung zugrunde liegenden theoretischen Betrachtungen

Die im Folgenden angestellten theoretischen Betrachtungen beziehen sich auf die Bestimmung der für die Ansprechempfindlichkeit des neuen Sensors maßgeblichen Größen und die Berücksichtigung dieser Ergebnisse und Erkenntnisse beim Aufbau des Antennensystems.

1.3.1 Abschirmung des Antennensystems beim neuen Sensor

Der neue Sensor besitzt ein Antennensystem. Die Annäherung eines Objekts (Person oder Gegenstand) an die Antenne dieses Systems bewirkt eine Änderung der Antennenausgangsspannung, die zu Schalt-, Meß bzw. Regelzwecke genutzt wird.

Damit eine genügend starke Beeinflussung der Antenne durch das sich nähernde Objekt gegeben ist, muß die negative Einwirkung der in Antennennähe befindlichen, auf Erdpotential liegenden Teile weitgehend unterbunden werden. Die Antenne des neuen Sensors, eine Flächenantenne, ist zu diesem Zweck in einen einseitig offenen Abschirmbecher eingelassen, so daß eine Beeinflussung durch das sich nähernde Objekt nur von der offenen Becherseite her gegeben ist. Da aus bereits genannten Gründen beim Aufbau des neuen Sensors keine Gleich- sondern die von einem Sinusoszillator erzeugte Schwingkreiswechselspannung verwendet wird, ist die Flächenantenne auch nur wechselspannungsmäßig gegenüber seitlich neben der Antenne gelegene, auf Masse (Erde) befindliche Teile abzuschirmen. Dieses wird dadurch erreicht, indem dem Abschirmbecher vom niederohmigen Ausgang des Antennenverstärkers das Antennenwechselspannungspotential aufgeprägt wird. Da somit zwischen Antenne und Abschirmung kein Wechselspannungspotentialunterschied mehr besteht, fließt zwischen beiden auch kein Ladestrom, d.h., durch die Abschirmung wird eine Masseeinwirkung auf die Antenne durch seitlich von ihr gelegene, auf Massepotential befindliche Teile unterbunden.

Die Wirkungsweise der Abschirmung läßt sich rechnerisch an folgendem Prinzipschaltbild (siehe Bild 7) näher erläutern. Die hierbei verwendeten Kurzbezeichnungen haben folgende Bedeutung:

$C_{EM}$ = Kapazität zwischen Abschirmung E und Masse M

$C_{WE}$ = Kapazität zwischen Antenne W und Abschirmung E

$i_{EM}$ = Ladestrom zwischen Abschirmung E und Masse M

$i_{WE}$ = Ladestrom zwischen Antenne W und Abschirmung E

$u_{EM}$ = Wechselspannungspotential zwischen Abschirmung E und Masse M

$u_{WE}$ = Wechselspannungspotential zwischen Antenne W und Abschirmung E

$u_{WM}$ = Wechselspannungspotential zwischen Antenne W und Masse M

$u_{WN}$ = Wechselspannungspotential zwischen Antenne W und Nullpotential N des Netzteils NT

<Die Größen $u_{WE}$ und $i_{WE}$ stehen in folgende Beziehung zueinander:

$$u_{WE} = \frac{1}{C_{WE}} \int i_{WE} \cdot dt$$

$$C_{WE} = \frac{1}{u_{WE}} \int i_{WE} \cdot dt$$

Bei kapazitiver Last eilt der Strom (siehe Bild 8) gegenüber der Spannung um 9o° vor:

$$i_{WE} = I_{WE} \cos wt \quad u_{WE} = U_{WE} \sin wt$$

Mit

$$\int i_{WE} \cdot dt = I_{WE} \int \cos wt \cdot dt$$
$$= \frac{I_{WE}}{w} \cdot \sin wt$$

folgt

$$C_{WE} = \frac{1}{U_{WE} \cdot \sin wt} \cdot \frac{I_{WE}}{w} \cdot \sin wt$$
$$= \frac{1}{w} \cdot \frac{I_{WE}}{U_{WE}}$$
$$= \frac{1}{2 \cdot 3,14 \cdot f} \cdot \frac{I_{WE}}{U_{WE}}$$

wobei $I_{WE}$ die Amplitude des zwischen Antenne W und Abschirmung E fließenden Ladestromes $i_{WE}$, $U_{WE}$ die Amplitude des Wechselspannungspotentials zwichen Antenne W und Abschirmung E und f ihre Frequenz (entspricht der Schwingkreisfrequenz $f_o$ - siehe Sinusoszillator SO, Kapitel 1.5.1o) ist.

Für den Abschirmungsfall

$$u_{EM} = u_{WM}$$

wird, auf die Amplitudenwerte übertragen,

$$U_{WE} = U_{WM} - U_{EM}$$
$$= o$$

und damit ebenfalls

$$C_{WE} = \frac{1}{w} \cdot \frac{I_{WE}}{U_{WE}}$$
$$I_{WE} = w \cdot C_{WE} \cdot U_{WE}$$
$$= O$$

Eine kapazitive Einwirkung der Abschirmung auf die Antenne besteht in diesem Fall also nicht. Die Abschirmung unterbindet lediglich die Masseeinwirkung der in Antennennähe liegenden, auf Massepotential befindlichen Teile. Dabei zeigt sie gegenüber der Antenne ein völlig neutrales Verhalten

Zwischen Abschirmung E und Masse M liegt jedoch das volle Wechselspannungspotential

$$u_{EM} = u_{WM}$$
$$= \frac{1}{C_{EM}} \int i_{EM} \cdot dt$$

mit dem Ladestrom

$$i_{EM} = C_{EM} \cdot \frac{du_{EM}}{dt}$$
$$= C_{EM} \cdot \frac{du_{WM}}{dt}$$
$$= C_{EM} \cdot \frac{dU_{WM} \cdot \sin wt}{dt}$$
$$= w \cdot C_{EM} \cdot U_{WM} \cdot \cos wt$$
$$= 2 \cdot 3{,}14 \cdot f \cdot C_{EM} \cdot U_{WM} \cdot \cos wt$$

, der vom niederohmigen Ausgang des Antennenverstärkers aufgebracht werden muß.

Da $U_{WM}$ dem Spannungsabfall $U_{CWM}$ über der Antennenmassekapazität $C_{WM}$ entspricht, kann die Gleichung auch, wie folgt, geschrieben werden:

$$i_{EM} = 2 \cdot 3{,}14 \cdot f \cdot C_{EM} \cdot U_{CWM} \cdot \cos wt$$

1.3.2 Beeinflussung des Antennensystems durch Annäherung eines Objekts

Die Schwingkreiswechselspannung $u_S$ des Sinusoszillators SO wird über den hochohmigen Antennenwiderstand R (siehe Bild 9) der Antenne W zugeführt.

Die Antenne ist durch die Antennenmassekapazität $C_{WM}$, deren Größe zu einem späteren Zeitpunkt (siehe Kapitel 1.3.4) näher bestimmt werden soll, bereits vorbelastet, d.h., die Antenne liegt am Mittelabgriff des von Antennenwiderstand R und Antennenmassekapazität $C_{WM}$ gebildeten Spannungsteilers. Die Amplitude der gegen Masse gemessenen Antennenwechselspannung

$$U_{WM} = U_{CWM}$$

ist damit bereits kleiner als die Amplitude $U_S$ der Schwingkreiswechselspannung $u_S$.

Durch Annäherung eines Objekts O, einer Person bzw. eines Gegenstandes, an die Antenne W wird eine weitere Kapazität $C_{WO}$, die Kapazität zwischen Antenne W und Objekt O, parallel zur Antennenmassekapazität $C_{WM}$ geschaltet. Diese zusätzliche kapazitive Belastung bewirkt eine weitere Verringerung der gegen Masse gemessen Antennenwechselspannungsamplitude $U_{WM}$ von $U_{CWM}$ auf $U_{CWO}$ und damit eine Zunahme der gegen Nullpotential N des Netzteils gemessenen Antennenwechselspannungsamplitude $U_{WN}$, die dem Wechselspannungsabfall $U_R$ über dem Antennenwiderstand R entspricht, von $U_{RM}$ auf $U_{RO}$.

Diese Amplitudenzunahme

$$\Delta U_W = U_{RO} - U_{RM}$$

die für Schalt-, Meß- bzw. Regelzwecke genutzt wird, läßt sich rechnerisch, wie folgt, bestimmen:

a) Amplitude $U_{RM}$ der Antennenwechselspannung $u_W$ über dem Antennenwiderstand R, d.h., zwischen Antenne W und Nullpotential N des Netzteils gemessen, bei freier Antenne - (ohne Objektannäherung - siehe Bild 1o) Mit

$$U_{CWM} = \frac{U_{RM}}{R} \cdot \frac{1}{w \cdot C_{WM}}$$

folgt aus

$$U_S^2 = U_{RM}^2 + U_{CWM}^2$$

die Größe

$$U_S^2 = U_{RM}^2 + \frac{U_{RM}^2}{R^2} \cdot \frac{1}{w^2 \cdot C_{WM}^2}$$

$$= U_{RM}^2 \left( 1 + \frac{1}{w^2 \cdot R^2 \cdot C_{WM}^2} \right)$$

$$U_{RM} = \frac{U_S}{\sqrt{1 + \frac{1}{w^2 \cdot R^2 \cdot C_{WM}^2}}}$$

b) Amplitude $U_{RO}$ der Antennenwechselspannung $u_W$ über dem Antennenwiderstand R, d.h., zwischen Antenne W und Nullpotential N des Netzteils gemessen, bei Annäherung eines Objekts O an die Antenne (siehe Bild 11) Da die Antennenobjektkapazität $C_{WO}$ lediglich eine Vergrößerung der Antennenmassekapazität $C_{WM}$ bedeutet, läßt sich das Ergebnis ohne erneute Ableitung niederschreiben:

$$U_{RO} = \frac{U_S}{\sqrt{1 + \frac{1}{w^2 \cdot R^2 ( C_{WM} + C_{WO} )^2}}}$$

c) Amplitudenzunahme $\Delta U_W$ der Antennenwechselspannung $u_W$ über dem Antennenwiderstand R, d.h., zwischen Antenne W und Nullpotential N des Netzteils gemessen, bei Annäherung eines Objekts O an die Antenne

Die Amplitudenzunahme ist gleich der Differenz der unter a) und b) gefundenen Größen: $\Delta U_W = U_{RO} - U_{RM}$

$$= U_S \left\{ \frac{1}{\sqrt{1 + \frac{1}{w^2 \cdot R^2 ( C_{WM} + C_{WO} )^2}}} - \frac{1}{\sqrt{1 + \frac{1}{w^2 \cdot R^2 \cdot C_{WM}^2}}} \right\}$$

### 1.3.3 Ansprechempfindlichkeit des Antennensystems beim neuen Sensor

Um eine genau definierte Aussage bezüglich der Ansprechempfindlichkeit des Antennensystems beim neuen Sensor machen zu können, muß zur Bestimmung der für diese Ansprechempfindlichkeit maßgeblichen Größen die Gleichung für die Amplitudenzunahme $\Delta U_W$ der Antennenwechselspannung $u_W$ (siehe Kapitel 1.3.2) durch Anpassung an das spezielle Verhalten dieses Sensors vereinfacht werden.

Bezogen auf die Amplitudenwerte der jeweiligen Größen lassen sich an dieser Gleichung folgende Umformungen durchführen:

Die Schwingkreisausgangsspannung $U_S$ (siehe Bild 12) des Sinusoszillators (siehe Bild 13 und Kapitel 1.5.1o) ergibt sich aus der vektoriellen Addition der Verstärkerausgangsspannung $U_A$ und der Resonanzspannung

$U_o$. Die Resonanzspannung $U_o$, die dem Spannungsabfall über der Induktivität L bzw. der Kapazität C bei Resonanz entspricht, ist um den Gütefaktor q des Parallelschwingkreises größer als die Verstärkerausgangsspannung $U_A$:

$$U_o = q \cdot U_A$$

Die Verstärkerausgangsspannung $U_A$ stimmt größenmäßig widerum mit dem Spannungsabfall über dem Verlustwiderstand $R_V$ überein.

Zwischen der Schwingkreisausgangsspannung $U_S$ und der Versorgungsspannung $\pm$ U, die annähernd gleich der Verstärkerausgangsspannung $U_A$ ist, besteht folgender rechnerischer Zusammenhang:

$$U_S^2 = U_A^2 + U_o^2$$

$$= U_A^2 + q^2 \cdot U_A^2$$

$$= (1 + q^2) \cdot U_A^2$$

$$U_S = \sqrt{1 + q^2} \cdot U_A$$

oder für $q \gg 1$

$$U_S = q \cdot U_A = \pm q \cdot U$$

Da eine Weiterverarbeitung der Antennenwechselspannung $U_W = U_{RM}$ nur möglich ist, wenn sich $U_{RM}$ entsprechend $U_A$ ebenfalls innerhalb des Versorgungsspannungsbereich $\pm$ U bewegt, muß zwischen $U_{RM}$ und der über der Antennenmassekapazität $C_{WM}$ abfallenden Wechselspannung das gleiche Spannungsverhältnis wie zwischen $U_A$ und $U_o$ bestehen:

$$U_{CWM} = q \cdot U_{RM}$$

Wie aus dem Vektordiagramm (siehe Bild 14) hervorgeht, sind $U_{RM}$ and $U_{CWM}$ die beiden Katheden im Thaleskreis über der Hypotenuse $U_S$. Für

$$U_{CWM} \gg U_{RM}$$

(siehe Bild 15) hat demzufolge bei Objektannäherung eine kleine Amplitudenabnahme $\Delta U_{WM}$ von $U_{CWM}$ auf $U_{CWO}$ eine große Amplitudenzunahme $\Delta U_W$ von $U_{RM}$ auf $U_{RO}$ zur Folge, was einer hohen Ansprechempfindlichkeit des Sensors entspricht. Durch Einsetzen des Wertes

$$U_{CWM} = q \cdot U_{RM}$$

in

$$U_{CWM} = q \cdot U_{RM}$$

$$U_{CWM} = \frac{U_{RM}}{R} \cdot \frac{1}{w \cdot C_{WM}}$$

(siehe Kapitel 2.3.2) folgt die Beziehung

$$q \cdot U_{RM} = \frac{U_{RM}}{R} \cdot \frac{1}{w \cdot C_{WM}}$$

$$\frac{1}{R \cdot w \cdot C_{WM}} = q$$

, die für $q \gg 1$ übergeht in:

$$\frac{1}{R \cdot w \cdot C_{WM}} \gg 1$$

Da bei eingestelltem großen Sensornennabstand (mit hoher Ansprechempfindlichkeit) eine Objektannäherung nur einer geringfügigen Vergrößerung der Antennenmassekapazität gleichkommt, gilt für diesen Fall analog:

$$\frac{1}{R \cdot w \left( C_{WM} + C_{WO} \right)} \gg 1$$

In der Gleichung für die Amplitudenzunahme der Antennenwechselspannung bei Annäherung eines Objekts an die Antenne

$$\Delta U_W = U_S \left\{ \frac{1}{\sqrt{1 + \frac{1}{w^2 \cdot R^2 \left( C_{WM} + C_{WO} \right)^2}}} - \frac{1}{\sqrt{1 + \frac{1}{w^2 \cdot R^2 \cdot C_{WM}^2}}} \right\}$$

kann damit der Wert 1 in beiden Wurzelausdrücken vernachlässigt werden. Dieses führt zu der Vereinfachung:

$$\Delta U_W = U_S \left[ \sqrt{w^2 \cdot R^2 \left( C_{WM} + C_{WO} \right)^2} - \sqrt{w^2 \cdot R^2 \cdot C_{WM}^2} \right]$$

$$= U_S \cdot R \cdot w \cdot C_{WO}$$

Durch Einsetzen der Werte

$$\frac{1}{R \cdot w \cdot C_{WM}} = q$$

$$R \cdot w = \frac{1}{q \cdot C_{WM}}$$

und

$$U_S \lessgtr \pm q \cdot U$$

folgt hieraus das endgültige Ergebnis für die Amplitudenzunahme der Antennenwechselspannung bei Objektannäherung an die Antenne

$$\Delta U_W \lessgtr \pm \frac{q \cdot U}{q} \cdot \frac{C_{WO}}{C_{WM}}$$

$$\Delta U_W \lessgtr \pm U \cdot \frac{C_{WO}}{C_{WM}}$$

### für q ≫ 1 bei

$$R = \frac{1}{q} \cdot \frac{1}{w \cdot C_{WM}}$$

Die Auswertung dieses Ergebnisses zeigt, daß bei einer Schwingkreiswechselspannungsamplitude $U_S$, die bedeutent größer als die Versorgungsspannung $\pm U$ ist, die amplitudenzunahme der Antennenwechselspannung $\Delta U_W$, d.h., die Ansprechempfindlichkeit des neuen Sensors bei Objektannäherung, proportional dieser Versorgungsspannung und proportional dem Quotient aus Antennenobjekt- und Antennenmassekapazität, $C_{WO}$ und $C_{WM}$, ist.

Das sich nähernde Objekt wirkt also über die Antennenobjektkapazität $C_{WO}$ um so stärker auf die Antenne ein, je geringer die Antenne durch die Antennenmassekapazität $C_{WM}$ bereits vorbelastet ist.

### und

für q ≫ 1 erfüllt sein müssen.

Beim neuen Sensor ist daher zur Erzielung einer hohen Ansprechempfindlichkeit der mechanisch-schaltungstechnische Aufbau des Antennensystems so konzipiert, daß die Antennenmassekapazität $C_{WM}$ möglichst klein gegenüber der Antennenobjektkapazität $C_{WO}$ ist und am Antennenwiderstand R durch entsprechende Wahl der Größe dieses Widerstandes nur etwa der q-te Teil der Schwingkreiswechselspannung $U_S$ bei Objektannäherung auf Nennabstand anliegt.

1.3.4 Reduzierung der Antennenmassekapazität $C_{WM}$ beim neuen Sensor

Die Antenne W wird durch die Antennenmassekapazität $C_{WM}$, die Kapazität zwischen der Antenne und den seitlich von ihr befindlichen, auf Massepotential liegenden Teilen, bereits vorbelastet. Die Untersuchung der Beeinflussung des Antennensystems durch ein der Antenne sich näherndes Objekt O (, wie in Kapitel 1.3.2 und 1.3.3 beschrieben,) führte zu der Forderung, daß zum Erreichen einer großen Antennenwechselspannungsänderung $\Delta U_W$ und deren Nutzung die Bedingungen

$$C_{WM} < C_{WO}$$
$$U_{RM} \lessgtr \pm U$$
$$\lessgtr \frac{1}{q} \cdot U_S$$

$$R \lessgtr \frac{1}{q} \cdot \frac{1}{w \cdot C_{WM}}$$

Die Antennenmassekapazität $C_{WM}$ setzt sich aus folgenden Teilkapazitäten zusammen:

$$C_{WM} = C_{WA} + C_{WE} + C_{WT}$$

Hierbei bedeutet:

$C_{WA}$ = Kapazität zwischen Antenne W und Antennenverstärker AV

$C_{WE}$ = Kapazität zwischen Antenne W und Abschirmung E

$C_{WT}$ = Kapazität zwischen Antenne W und den von der Abschirmung nicht erfaßten, hauptsächlich vor der Antenne befindlichen, auf Massepotential (Erdpotential) liegenden Teile T

Eine wirkungsvolle Verringerung der Antennenmassekapazität $C_{WM}$ ist also nur möglich, wenn es gelingt, sämtliche Teilkapazitäten $C_{WA}$, $C_{WE}$ und $C_{WT}$ auf einen bestimmten Minimalwert zu reduzieren.

1.3.4.1 Kapazität $C_{WE}$ zwischen Antenne W und Abschirmung E Eine völlige Kompensation des Masseeinflusses der Abschirmung E auf die Antenne W ist bei einem Verstärkungsfaktor V = 1 des Antennenverstärkers AV

$$C_{WE} = \frac{1}{w} \cdot \frac{I_{WE}}{U_{WE}}$$

(siehe Kapitel 1.3.1)

$$I_{WE} = w \cdot C_{WE} \cdot U_{WE}$$

mit

$$U_{WE} = U_{WM} = U_{EM},$$

daß der Ladungsstrom $I_{WE} = w \cdot C_{WE} ( U_{WM} - U_{EM} )$ dem Potentialunterschied zwischen Antennen- und Abschirmungswechselspannung $U_{WM}$ und $U_{EM}$, der Kreisfrequenz w und der Antennenabschirmungskapazität $C_{WE}$ direkt proportional ist.

Durch eine geringe Spannungsverstärkung von $U_{WM}$ über den Antennenverstärker AV (siehe Bild 16) kann eine Übereinstimmung zwischen Antennen- und Abschirmungswechselspannung ($U_{WM} = U_{EM}$) wieder erreicht werden, d.h., die Spannungsdifferenz $U_{WE}$ ausgeglichen und der Ladestrom $I_{WE}$ auf den Wert Null gebracht werden.

nicht möglich. Der zwischen Abschirmung E und Masse M (Erde) fließende Ladungsstrom $i_{EM}$ belastet den Antennenverstärkerausgang, so daß die Abschirmung dem Wechselspannungspotential der Antenne nicht ganz folgen kann. Der Potentialunterschied zwischen Antenne W und Abschirmung E

$$U_{WE} = U_{WM} - U_{EM}$$

hat einen Ladungsstrom $i_{WE}$ mit der Wechselstromamplitude $I_{WE}$ zur Folge. Damit verhält sich die Abschirmung gegenüber der Antenne nicht mehr neutral. Sie wirkt über die Kapazität $C_{WE}$ auf die Antenne ein.

Auf die Amplitudenwerte übertragen ergibt sich aus

Über eine geringfügige Überkompensation, d.h., durch ein weiteres Anheben von $U_{EM}$ über $U_{WM}$ hinaus mit entgegengesetzt gerichtetem Ladungsstrom $I_{WE}$ kann sogar zusätzlich eine Steigerung der Ansprechempfindlichkeit des Antennensystems erreicht werden (Verringerung der Antennenmassekapazität $C_{WM}$ durch Überkompen sation). Die Anhebung der Ausgangsspannung $U_{EM}$ des Antennenverstärkers AV auf den für einen Ausgleich erforderlichen Spannungswert $U_{\oplus EM} = U_{WM} + U_{WE} = U_{WM} + U_{WM} - U_{EM} = 2 \cdot U_{WM} - U_{EM}$ ergibt sich aus dem Widerstandsverhältnis der Widerstände $R_A$ zu $R_E$. Bei gewählter Widerstandsgröße $R_E$ folgt für $R_A$:

$$\frac{U_{\oplus EM}}{U_{WM}} = V$$

$$= \frac{R_E + R_A}{R_E}$$

$$= 1 + \frac{R_A}{R_E}$$

oder mit

$$U_{\oplus EM} = 2 \cdot U_{WM} - U_{EM}$$

$$\frac{2 \cdot U_{WM} - U_{EM}}{U_{WM}} = 1 + \frac{R_A}{R_E}$$

$$2 - \frac{U_{EM}}{U_{WM}} = 1 + \frac{R_A}{R_E}$$

$$R_A = R_E \left( 1 - \frac{U_{EM}}{U_{WM}} \right)$$

## 1.3.4.2 Kapazität $C_{WA}$ zwischen Antenne W und Antennenverstärker AV

Die in den Abschirmbecher E hineinragenden Teile des Antennenverstärkers AV wirken potentialmäßig auf die Antenne W ein und erhöhen somit die Antennenmassekapazität $C_{WM}$.

Diese negative Einwirkung auf die Antenne wird beim neuen Sensor dadurch unterbunden, indem sämtlichen Antennenverstärkeranschlüssen, die in den zwischen Abschirmung E und Antenne W eingeschlossenen Raum hineinragen, das Antennenwechselspannungspotential $u_W$ aufgeprägt wird. Da der Opertionsverstärker als Spannungsfolger geschaltet ist, stimmen seine Eingänge und sein Ausgang mit dem Antennenwechselspannungspotential $u_W$ bereits überein, so daß nur noch die Versorgungsspannungsanschlüsse +U und -U auf Antennenwechselspan nungspotential gebracht werden müssen (siehe Bild 17). Dieses erfolgt durch Abgreifen der positiven Versorgungsspannung +U am Emitterfolger V1 (NPN-Transistor), dem eingangsseitig über Kondensator C1 das Antennenwechselspannungspotential $u_W$ des Antennenverstärkerausgangs zugeführt wird, und durch Abgreifen der negativen Versorgungsspannung -U am Emitterfolger V2 (PNP-Transistor), dem eingangsseitig über Kondensator C2 das gleiche Antennenwechselspannungspotential zugeführt wird.

Die Arbeitspunkteinstellung des Operationsverstärkers wird über die Widerstände

$$R1 + R2 = R \text{ bei } R1 \ll R2$$

(Antennenwiderstand) vorgenommen, über die gleichzeitig auch die Schwingkreiswechselspannung $u_S$ des Sinusoszillators der Antenne zugeführt wird.

Abschließend wird nochmals darauf hingewiesen, daß beim gewählten Aufbau des Antennensystems nur elektronische Bauelemente und Leiterbahnen des Antennenverstärkers, die Antennenwechselspannungspotential $u_W$ führen, in den von Abschirmbecher und Flächenantenne eingeschlossenen Raum hineinreichen, der übrige Teil des Antennenverstärkers jedoch außerhalb dieses Raumes angeordnet ist.

## 1.3.4.3 Kapazität $C_{WT}$ zwischen Antenne W und den vor der Antenne befindlichen, auf Erdpotential M liegenden Teile T

Die Masseeinwirkung auf die Antenne W durch vor der Antenne befindliche, auf Erdpotential M liegende Teile T kann nicht kompensiert werden, weil von dieser Seite aus die gewünschte Beeinflussung des Antennensystems durch das sich nähernde Objekt erfolgt, d.h., von dieser Seite aus das Antennensystem bezüglich Abschirmung offen ist. Durch eine entsprechende Anordnung des Antennensystems gegenüber diesen, vor der Antenne befindlichen Teilen und durch eine günstige Einstellung der Abschirmblende (siehe Kapitel 1.5.1) läßt sich jedoch die Größe der Kapazität $C_{WT}$ auf einen vertretbaren Minimalwert reduzieren.

## 1.4 Beispiele für den Einsatz der Erfindung, anhand von Blockschaltbildern näher erläutert

Bevor auf den schaltungstechnischen Aufbau der einzelnen Funktionseinheiten des neuen Sensors eingegangen wird, soll anhand einiger Beispiele der Einsatz dieses Sensors mit Hilfe von Blockschaltbildern näher erläutert werden.

Hierbei kommen folgende Funktionseinheiten in Anwendung:

AS = Antennensystem

AV = Antennenverstärker

GR = Gleichrichter

MV = Meßverstärker

NA = Nennabstandsvorgabe bzw. Nennabstand

NT = Netzteil

NK = Nullkorrekturstufe

RV = Regelverstärker

SA = Symmetrische Aditionsstufe

SE = Schaltpunkteinstellstufe

SG = Spitzengleichrichter

SO = Sinusoszillator

SS = Schaltstufe

ST = Stellglied

SW = Sollwertvorgabe

und werden folgende Größenbezeichnungen verwendet:

w = Sollwert (entspricht dem Nennabstand NA)

x = Regelgröße

$x_w$ = Regelabweichung

y = Stellgröße

1.4.1 Der neue Sensor als Distanzmeßgerät zum Messen von Abständen, Durchflußmengen usw.

Vom Sinusoszillator OS (siehe Bild 18) wird die Schwingkreiswechselspannung $u_S$ mit konstanter Frequenz f und Amplitude $U_S$, über den hochohmigen Antennenwiderstand dem Antennensystem $A_S$ zugeführt. Bei Annäherung eines Objekts O an die Antenne W vergrößert sich die kapazitive Antennenbelastung um den wert $C_{WO}$ von $C_{WM}$ auf $C_{WM} + C_{WO}$. Der Wechselspannungsabfall über dem Antennenwiderstand steigt an. Über den Antennenverstärker AV, ein Spannungsfolger, gelangt diese Wechselspannung zum Spitzengleichrichter SG. Seine Ausgangsgleichspannung wird in der Meßverstärkerstufe MV mit dem über Potentiometer einstellbaren, dem gewünschten Nennabstand NA zwischen Sensor und Objekt entsprechenden Gleichspannungswert verglichen (Soll-Istwertvergleich). Die sich dabei ergebende Spannungsdifferenz wird verstärkt und in einen analogen Stromwert umgewandelt, so daß das am Ausgang des Verstärkers angeschlossene Meßgerät MG (mit zweiseitigem Ausschlag) Abweichungen des Objekts O vom vorgegebenen Nennabstand NA durch einen entsprechenden rechten bzw. linken Zeigerausschlage anzeigt, je nachdem, ob der Sensor-Objektabstand größer bzw. kleiner als dieser Nennabstand ist.

1.4.2 Der neue Sensor als statischer Annäherungsschalter

Beim Einsatz des neuen Sensors als statischer Annäherungsschalter (siehe Bild 19) wird die Ausgangsgleichspannung des Spitzengleichrichters SG in der Schaltpunkteinstellstufe SE, einem Komparator, mit einem über Potentiometer einstellbaren, dem gewünschten Nennabstand NA zwischen Sensor und Objekt entsprechenden Gleichspannungswert verglichen (Soll-Istwertvergleich). Beim Überschreiten dieses Wertes infolge des Wechselspannungsanstiegs über dem Antennenwiderstand wird die Schaltstufe SS, ein Schmitttrigger mit Transistor-Schaltverstärker, durchgesteuert, d.h., ein Relais zum Abfallen gebracht bzw. der Optokoppler einer Thyristoreinheit, der die ,Rücktransformation' des Schaltsignals aus dem Huckepackbetrieb in die Erdpotentialebene bewirkt, gesperrt.

1.4.3 Der neue Sensor als dynamischer Annäherungsschalter

Der neue Sensor als dynamischer Annäherungsschalter (siehe Bild 2o) ist schaltungsmäßig eine Erweiterung des statischen Annäherungsschalters.

Nach erfolgter Einstellung des Nennabstandes NA, wie in Kapitel 1.4.2 beschrieben, wird die Nullkorrekturstufe NK, ein Integrator, zugeschaltet, die eine Soll-Istwert-Differenz am Ausgang der Schaltpunkteinstellstufe SE über ihren Eingang kurzfristig wieder ausregelt, d.h., bewegt sich ein Objekt innerhalb des beidseitig vom eingestellten Nennabstand liegenden Nennabstandbereichs, so spricht die Schaltstufe SS an, solange dieser Bewegungszustand anhält. Bei ruhendem Objekt fällt die Schaltstufe jedoch, unabhängig davon, ob sich das Objekt bereits außerhalb oder noch innerhalb des Nennabstandbereichs befindet, nach Ablauf der Ausregelungszeit wieder in die Ausgangslage zurück. Dieser Zustand bleibt bestehen, solange das Objekt in Ruhe verharrt.

1.4.4 Der neue Sensor als Türkantensicherung einseitig bzw. zweiseitig schließender Schiebetüren

Beim Einsatz des neuen Sensors als Türkantensicherung einseitig bzw. zweiseitig schließender Schiebetüren (siehe Bild 21) kann z.B. die Leistungsfähigkeit von Aufzugsanlagen durch eine Verringerung der Kabinenhaltezeit in den angefahrenen Stockwerken über eine kürzere Türschließzeit (kein mehrmaliges völliges Auflaufen der Schiebetüren während des Schließvorgangs bei verspätetem Zusteigen weiterer Personen in die Kabine) erheblich gesteigert werden und zusätzlich die Funktion der aus Sicherheitsgründen an den Türkanten der Schiebetüren geforderten Tastleisten von diesem Sensor übernommen werden.

Für diesen Anwendungsfall (siehe Bild 22) ist der Abschirmbecher E des Antennensystems AS als Abschirmrinne ausgebildet, in die als Antenne über die gesamte Rinnenlänge hinweg mittig ein Antennendraht W angeordnet ist. Da die Türschließkante beider Schiebetüren jeweils ein Antennensystem, das Antennensystem AS1 und AS2, enthält (bei einseitig schließender Schiebetüre ein Antennensystem in der Türschließkante und ein Antennensystem in der Schließkante der Seitenwand), muß die Schwingkreisausgangsspannung $u_S$ des Sinusoszillators SO auch den beiden Antennen W1 und W2 über getrennte Antennenwiderstände zugeführt werden. Während die beiden Antennenverstärker AV1 und AV2 im Aufbau gleich sind, unterscheiden sich die beiden Spitzengleichrichter SG1 und SG2 aufgrund unterschiedlicher Diodenanordnung durch ihre Amplitudengleichspannungswerte entgegengesetzter Polarität (positives und negatives Potential), die die Voraussetzungen für einen Nullabgleich, d.h., die Einstellung der beiden Antennensysteme AS1 und AS2 auf den gleichen Nennabstand NA (gleiche Ansprechempfindlichkeit) mit Hilfe des Potentiometers der symmetrischen Additionsstufe SA, sind. Während sich bei einer gleichzeitigen, gleichen Beeinflussung beider Antennensysteme (beim Auflaufen bzw. Schließen der Schiebetüren ohne Anwesenheit eines Objekts) dieser Nullabgleichwert nur unwesentlich ändert, ergibt sich bei einer einseitigen Objektannäherung an eines dieser beiden Antennensysteme am Ausgang der symmetrischen Additionsstufe eine der Differenz der beiden Antennenwechselspannungen entsprechende Amplitudengleichspannung, deren Polarität, abhängig vom jeweiligen Antennensystem, positiv bzw. negativ sein kann. Zur Anpassung der symmetrischen Additionsstufe AS an die Schaltpunkteinstellstufe SE (Soll-Istwertvergleichsstufe) ist damit das Zwischenschalten eines Gleichrichters GR erforderlich.

1.4.5 Der neue Sensor als Abstandsregler

Der neue Sensor als Abstandsregler zur Regelung des Sensor-Objektabstandes (siehe Bild 23) stellt ein geschlossenes Regelsystem dar.

Aus der durch Soll-Istwertvergleich erhaltenen Regelabweichung

$$x_w = x - w$$

wird über den Regelverstärker RV die Stellgröße y erarbeitet, die mit Hilfe des Stellglieds ST das Objekt O gegenüber der Antenne W auf Nennabstand NA hält. Da es sich bei vorliegender Abstandsregelung um ein reines Regelproblem handelt, wird von einer näheren Beschreibung des neuen Sensors als Abstandsregler hier abgesehen.

1.5 Mechanischer und schaltungstechnischer Aufbau der einzelnen Funktionseinheiten der Erfindung

Die Beschreibung des mechanischen und schaltungstechnischen Aufbaus der einzelnen Funktionseinheiten der Erfindung erfogt unter Bezugnahme auf die entsprechenden Blockschaltbilder (siehe Kapitel 1.4.1 bis 1.4.5), wie folgt:

1.5.1 Antennensystem AS mit Antenne W und Antennenverstärker AV

1. Antenne W

Das Antennensystem AS besitzt als Abschirmung einen Metallbecher mit niedrigem spezifischen Widerstand, in den von vorne, frei zugänglich, die Flächenantenne W eingelassen ist (siehe Bild 24). Hinter dieser Flächenantenne, innerhalb dieses Abschirmbechers ist die Leiterplatte mit den elektronischen Bauelementen des Antennenverstärkers, die sich auf Antennenwechselspannungspotential befinden, angeordnet. Zur Veränderung der Wahrnehmungszone, d.h., zur Formung des vor der Antenne befindlichen, hochfrequenten, elektromagnetischen Feldes, ist der Abschirmbecher zusätzlich mit einer verstellbaren Abschirmblende B versehen.

Die Antennenwechselspannung $u_W$ entspricht dem am Widerstand

$$R = R1 + R2$$

abfallenden Teil der Schwingkreiswechselspannung $u_S$. Sie nimmt (siehe Bild 25 bis 27):

a) für (theoretischer Wert, praktisch nicht erreichbar) den Wert $u_W = 0$ an,

b) für

$$\frac{1}{w \left( C_{WM} + C_{WO} \right)} \longrightarrow q \cdot R$$

(Arbeitsbereich des neuen Sensors) den Wert

$$u_W = \pm \frac{1}{q} \cdot u_S \text{ an und}$$

c) für

$$\frac{1}{w \left( C_{WM} + C_{WO} \right)} \longrightarrow 0$$

(im Falle eines Antennenmasseschlusses) den Wert $u_W = u_S$ an.

Das Antennenwechselspannungspotential $u_W$, das leistungsverstärkt am Ausgang des Antennenverstärkers AV als Ausgangsspannung

$$u_E \gtrless u_W$$

zur Verfügung steht, wird zur Erzielung der gewünschten Abschirmwirkung der Abschirmung E aufgeprägt (siehe Kapitel 1.3.1 und 1.3.4.3)

### 2. Antennenverstärker AV

Die Wirkungsweise der Schaltung wurde bereits bei der Beschreibung der Verfahren zur Verringerung der Antennenmassekapazität $C_{WM}$ erläutert, so daß hier anhand des Antennenwiderstands R und der Ausgangsspannung $u_E$ des Antennenverstärkers AV (siehe Bild 28) abschließend eine zusammenfassende Darstellung der Funktionsweise folgt.

Der Antennenwiderstand übernimmt drei Funktionen:

a) Er bewirkt über seine beiden Teilwiderstände R1 + R2 = R die Arbeitspunkteinstellung des Antennenverstärkers AV

b) Er ist Teilwiderstand des parallel zum Parallelschwingkreis des Sinusoszillators SO geschalteten Spannungsteilers, der aus diesem Widerstand und dem durch Parallelschaltung von Antennenmasse- und Antennenobjektkapazität, $C_{WM}$ und $C_{WO}$, gebildeten kapazitiven Widerstand besteht.

c) Er führt den über ihm abfallenden Teil der Schwingkreiswechselspannung auf den Eingang des Antennenverstärkers AV und ist damit der Eingangwiderstand dieses Verstärkers.

Die Ausgangsspannung des Antennenverstärkers erfüllt ebenfalls drei Funktionen:

a) Sie bewirkt, geringfügig verstärkt, in Verbindung mit der Abschirmung E eine weitgehende Kompensation störender Masseeinwirkungen auf die Antenne W und darüber hinaus durch Überkompensation eine Steigerung der Ansprechempfindlichkeit des Sensors.

b) Sie prägt über den Kondensator C1 bzw. C2 den Emitterfolgern V1 bzw. V2 und damit der positiven bzw. negativen Versorgungsspannung des Operationsverstärkers das Antennenwechselspannungspotential auf.

c) Ihre Änderung bei Objektannäherung an die Antenne wird für Schalt-, Meß- bzw. Regelzwecke genutzt.

Beim Einsatz des neuen Sensors als Näherungsschalter folgt im Anschluß an das Antennensystem (siehe Bild 24) das Schaltgerät SG mit Anschlußkabel K und den in Kapitel 1.4.2 beschriebenen Funktionseinheiten.

### 1.5.2 Spitzengleichrichter SG

Durch eine Spitzengleichrichtung der Ausgangsspannung $u_E$ des Antennenverstärkers AV wird die Ansprechempfindlichkeit des neuen Sensors gesteigert. Die Ist-Sollwertabweichung ist in diesem Fall abhängig von der Amplitudenänderung der Ausgangswechselspannung $u_E$ des Antennenverstärkers AV, die der Antennenwechselspannung $u_W$ angenähert entspricht, und nicht von der Änderung ihres Gleichspannungsmittelwertes. Die Funktionsweise des Spitzengleichrichters ist folgende (siehe Bild 29):

Bei Abfall der Eingangswechselspannung auf den negativen Amplitudenwert $-U_E$ wird der Kondensator C1 bei einer Verstärkung

$$V = \frac{R_{A1}}{R_{E1}} = 1$$

des invertierenden Verstärkers N auf die Amplitudenspitzengleichspannung $+U_E$ aufgeladen. Eine Entladung des Kondensators kann nur, da D1 in Sperrichtung liegt, über den Widerstand $R_{A1}$ und den Eingangswiderstand $R_{E2}$ der folgenden Stufe erfolgen. Bei Anstieg der negativen Eingangswechselspannung auf den Wert $U_E = o$ erreicht der Ausgang des Verstärkers N den Wert $-U_{E/2}$, da die Amplitudenspitzenspannung $+U_E$ des Kondensators C1 über den Widerstand $R_{A1}$ auf den Eingang E zurückwirkt und der Widerstandswert $R_{A2}$ halb so groß wie der Widerstandswert $R_{A1}$ ist. Für die Eingangsspannung $+U_E$ wird die Ausgangsspannung $-U_E$. Jetzt wird dem Verstärkereingang neben dem über $R_{A1}$ eingespeisten Gleichstrom über $R_{E1}$ zusätzlich ein gleich großer Amplitudenstrom zugeleitet.

Durch Wahl des Widerstandverhältnisses $R_{A2} = R_{A1/2}$, das auch bei einem Verstärkungsfaktor

$$V = \frac{R_{A1}}{R_{E1}} > 1$$

beibehalten werden muß, wird also in Verbindung mit der Diode D2 eine Übersteuerung des Verstärkers N verhindert und durch die Diode D1 eine Einwirkung der negativen Verstärkerausgangsspannung $-U_E$ auf den Kondensator C1 unterbunden. Der Kondensator C2 wirkt als Gegenkopplung im Spitzenspannungsbereich, d.h., er wirkt Störspannungen entgegen, die zur Auslösung von Fehlschaltungen führen können.

1.5.3 Symmetrische Additionsstufe SA mit Gleichrichter GR

Der Nennabstand NA, d.h., der Abstand zwischen Antenne W und dem sich nähernden Objekt O, bei dem die Schaltstufe SS des neuen Sensors anspricht, muß für beide Antennensysteme AS1 und AS2 der Türkantensicherung einseitig bzw. zweiseitig schließender Schiebetüren nicht unbedingt gleich sein.

Unterschiede sind gegeben wenn:

a) die beiden Antennensysteme AS1 und AS2 in ihrem mechanischen Aufbau nicht völlig übereinstimmen

b) die Antennenverstärker AV1 und AV2 und die Spitzengleichrichter SG1 und SG2 infolge Bauelementeabweichungen unterschiedliches elektrisches Verhalten zeigen

c) Abweichungen in der Leitungsführung zwischen den Antennenverstärkern AV1 und AV2 und den im Schaltgerät

SG befindlichen Spitzengleichrichtern SG1 und SG2 bestehen.

Zum Ausgleich dieser Unterschiede enthält die symmetrische Additionsstufe AS mit Gleichrichter GR zum symmetrischen Abgleich ein Potentiometer P (siehe Bild 30). Dieses Potentiometer hat die Aufgabe, die Amplitudengleichspannungswerte der beiden Spitzengleichrichter GR1 und GR2 mit entgegengesetzter Polarität so zu addieren, daß nach richtig durchgeführtem Abgleich bei Annäherung eines Objekts beide Antennensysteme jeweils im gleichen Nennabstand die Schaltstufe zum Ansprechen bringen.

Da das Ausgangssignal der symmetrischen Additionsstufe SA bei Objektannäherung entsprechend dem jeweiligen Antennensystem AS1 bzw. AS2 sowohl positive als auch negative Werte annehmen kann, muß der Schaltpunkteinstellstufe SE (Soll-Istwertvergleichstufe) ein Gleichrichter GR vorgeschaltet werden.

Der vom Ausgang des Spannungsfolgers N1 dieses Gleichrichters über den Widerstand $R_{E1}$, auf den Eingang der Schaltpunkteinstellstufe SE gelangende Strom ist je nach Polarität der Ausgangsspannung positiv bzw. negativ. Da die Umkehrstufe N2 jedoch nur bei einer negativen Ausgangsspannung des Spannungsfolgers N1 über den Widerstand

$$R_{E2} = \frac{R_{E1}}{2}$$

den doppelten positiven Strom auf den Eingang der Schaltpunkteinstellstufe SE leitet, ist unabhängig von der jeweiligen Polarität der Ausgangsspannung des Spannungsfolgers N1 die Summe der Eingangsströme der Schaltpunkteinstellstufe SE stets positiv (Gleichrichterwirkung).

1.5.4 Schaltpunkteinstellstufe SE mit Nennabstandsvorgabe NA

Die Schaltpunkteinstellstufe (siehe Bild 31) übernimmt folgende Funktionen:

a) Die am invertierenden Eingang des Verstärkers N anliegende Spitzengleichspannung $+U_E$ wird entsprechend dem Widerstandsverhältnis $R_A$ zu $R_E$ (Verstärkungsfaktor $V = R_A/R_E$) verstärkt und mit Hilfe des Gegenkoppelkondensators C geglättet.

b) Mit der am Potentiometer P abgegriffenen positiven Teilspannung $+U_P$, die am nicht invertierenden Eingang des Verstärkers N liegt, kann der Schaltpunkt für die Schaltstufe

SS, d.h., der Nennabstand NA des neuen Sensors eingestellt werden.

Bei optimaler Einstellung, d.h. bei hoher Ansprechempfindlichkeit ist anfänglich die über den Eingangswiderstand $R_E$ am invertierenden Eingang des Verstärkers N anliegende positive Spitzengleichspannung $+U_E$ geringfügig kleiner als die am Potentiometer R abgegriffene positive Teilspannung $+U_P$, so daß der Verstärkerausgang positives Potential besitzt. Vergrößert sich jedoch durch Annäherung eines Objekts an die Antenne die Spitzengleichspannung $+U_E$ dann wird die resultierende Eingangsspannung positiv, d.h., die Verstärkerausgangsspannung

$$U_A = - V (U_P - U_E)$$

wird negativ und bewirkt ein Abfallen der Schaltstufe SS.

Beim dynamischen Annäherungsschalter übernimmt die Schaltpunkteinstellstufe SE zusätzlich die Funktion eines über den Rückführwiderstand $R_R$ angesteuerten Stellgliedts zur Durchführung der Nullkorrektur. Die Funktionsweise der Nullkorrekturstufe NK wird im folgenden Kapitel näher erläutert.

### 1.5.5 Nullkorrekturstufe NK

Bei der bisherigen Beschreibung wurde davon ausgegangen, daß in Abhängigkeit vom eingestellten Nennabstand NA bei einer bestimm ten Entfernung des sich nähernden Objekts von der Antenne die Schaltstufe SS des neuen Sensors anspricht und auch bei einer weiteren Annäherung an die Antenne in diesem Zustand verharrt. Erst nachdem das Objekt die Ansprechzone wieder verlassen hat, kehrt die Schaltstufe SS in ihre Ausgangslage zurück (statischer Schalter).

In vielen Anwendungsfällen ist es jedoch erwünscht, daß die Schaltstufe SS bei einer durch ein sich näherndes Objekt verursachten Antennenspannungsänderung $\Delta u_W$ nur kurzzeitig anspricht und dann in die Ausgangslage wieder zurückkehrt, d.h., bleibende Einwirkungen auf die Schaltstufe SS ohne Einfluß sind (dynamischer Schalter)

Dieses Verhalten wird durch eine zusätzliche Nullkorrekturstufe NK, einen Integrator, erreicht (siehe Bild 32), der die Amplitudenspannungsänderung verzögert über den Rückführwiderstand $R_R$ ausregelt, so daß die Schaltstufe SS nur kurzzeitig abfällt.

Den Schaltstellungen des Schalters S kommt folgende Bedeutung zu:

a) In Schaltstellung o erfolgt die Einstellung und der Betrieb des statischen Annäherungsschalters und die Voreinstellung des dynamischen Annäherungsschalters.

b) In Schaltstellung 1 erfolgt der Betrieb des dynamischen Annäherungsschalters. In dieser Betriebsart wird über die Nullkorrekturstufe NK die Schaltpunktrückstellung, deren Voreinstellung durch das Potentiometer P in Schaltstellung o des Schalters S bereits erfolgte, nach jeder Antennenwechselspannungsänderung $\Delta u_W$ (verursacht durch eine Objektbewegung in Antennennähe) erneut selbsttätig durchgeführt (Rückkehr der Schaltstufe in ihre Ausgangslage).

### 1.5.6 Meßverstärker MV mit Meßgerät MG bei Nennabstand NA als Bezugsgröße

Der Meßverstärker MV mit Meßgerät MG bei Nennabstand NA (siehe Bild 33) als Bezugsgröße entspricht im Prinzip der Schaltpunkteinstellstufe SE mit Nennabstandsvorgabe NA, wobei das Meßgerät MG, ein Amperemeter, die Objektabweichung vom Nennabstand über den Meßverstärkerausgangsstrom anzeigt.

Durch eine nichtlineare Rückführung $R_A$ kann der Ausschlag des Meßgerätes liniarisiert werden.

### 1.5.7 Schaltstufe SS

Die Schaltstufe SS (siehe Bild 34) besteht aus drei Einheiten:

- Schmitttrigger

- Siebglied und

- Schaltstufe mit Relais- bzw.Kontaktlosem Ausgang (Tyristoreinheit mit Optokoppler)

Der Verstärkungsfaktor des Schmitttriggers (invertierender Operationsverstärkereingang) ist

$$V = \frac{R_{A1}}{R_{E1}}$$

und der Mitkopplungsfaktor (nicht invertierender Operationsverstärkereingang) ist

$$M = \frac{R_{A2}}{R_{E2}} + 1$$

Die positive Verstärkerausgangsspannung läd den Kondensator $C_S$ des mit dem Widerstand $R_S$ gebildeten Siebgliedes auf. Beim Erreichen der Sperrspannung wird die Schaltstufe, bedingt durch den Mitkopplungswiderstand $R_M$, schlagartig gesperrt. Das Relais K fällt ab bzw. die Tyristoreinheit (Die Tyristoreinheit befindet sich auf der Primärseite des Netztransformators T, in Bild 36 nicht gezeichnet.) wird über den Optokoppler $D_L$ gesperrt. Erst bei negativer Verstärkerausgangsspannung und entsprechender Entladung des Kondensators $C_S$ über R1 und $R_S$ kehrt die Schaltstufe, über $R_E$ durchgesteuert, wieder in ihre Ausgangslage zurück. Durch diesen Schaltungsaufbau wird gewährleistet, daß die Schaltstufe nur dann sperrt, wenn vorher der Schmitttrigger bereits eine Zeit lang durchgesteuert wurde (positive Verstärkerausgangsspannung). Dadurch werden Störspannungen, die zu einem kurzzeitigen Ansprechen des Schmitttriggers führen, unterdrückt. Durch die gegenkoppelnde Wirkung des Kondensators $C_{A1}$ wird zusätzlich diesen Störspannungen entgegengewirkt.

1.5.8 Reglerverstärker RV mit Sollwertvorgabe SW und Stellglied ST

Von einer Beschreibung der Funktionseinheit, Reglerverstärker RV mit Sollwertvorgabe SW und Stellglied ST' - (siehe Bild 35) wird Abstand genommen, da es sich hier um ein reines (elektrisch, pneumatisch bzw. hydraulisch zu lösendes) Regelungsproblem handelt

1.5.9 Netzteil NT Das Netzteil NT liefert die beiden gegenüber Nullpotential N gleich großen, stabilisierten Gleichspannungen $+U$ und $-U$. Der Schaltungsaufbau des Netzteils ergibt sich wie folgt (siehe Bild 36)

Die an der Sekundärwicklung des Transformators T abgegriffene Wechselspannung wird über den Brückengleichrichter V1 gleichgerichtet und durch den Elektrolytkondensator $C_G$ und Widerstand $R_G$ geglättet. Über die Spannungsfolgerschaltung N1 mit der sich für $R_A = R_E$ ergebenden Verstärkung

$$V = \frac{U_A}{U_E}$$

$$= \frac{R_A + R_E}{R_E}$$

$$= \frac{R_E + R_E}{R_E}$$

$$= 2$$

erfolgt eine Stabilisierung dieser Versorgungsspannung auf den doppelten Wert der am Spannungsteiler aus Vorwiderstand $R_Z$ und Zenerdiode $V_Z$ abgegriffenen Referenzspannung.

Das Nullpotential des Netzteils, das der Referenzspannung entspricht, wird mit Hilfe eines zweiten Spannungsfolgers N2 mit dem Verstärkungsfaktor

$$V = \frac{U_A}{U_E} = 1$$

gebildet.

1.5.1o Sinusoszillator SO

Bezüglich Aufbau und Wirkungsweise des Sinusoszillators OS (siehe Bild 37) wird auf die am 18.01.84 beim Deutschen Patentamt in München 2, Zweibrückenstraße 12, eingereichte Patentanmeldung (Aktenzeichen der Patentanmeldung P 34o1531.o):"Sinusoszillator zur Erzeugung von ungedämpften elektrischen Schwingungen", verwiesen. Die beim Versuchsaufbau gewählte Oszillatorfrequenz liegt, wie bereits erwähnt, bei 1o k Hz.

Inhaltsverzeichnis

1.Beschreibung der Erfindung

1.1 Aufgabe, Einsatzbereich, Vorteile und augenblicklicher technischer Stand der kapazitiven Annäherungssensoren

1.1.1 Vorteile der Annäherungssensoren gegenüber herkömmlichen Befehlsgebern

1.1.2 Aufgabe und Wirkungsweise eines kapazitiven Annäherungssensors

1.1.3 Augenblicklicher technischer Stand der kapazitiven Annäherungssensoren

1.1.4 Bevorzugter Einsatzbereich des neuen Sensors

1.2 Funktionsschema und Wirkungsprinzip der Erfindung

1.2.1 Funktionsschema und Prinzipschaltbild 1

1.2.2 Funktionsschema und Prinzipschaltbild 2

1.2.3 Funktionsschema und Prinzipschaltbild 3

1.2.4 Das dem neuen Sensor zugrunde gelegte Wirkungsprinzip

1.3 Die dem Aufbau des Antennensystems der Erfindung zugrunde liegenden theoretischen Betrachtungen

1.3.1 Abschirmung des Antennensystems beim neuen Sensor

1.3.2 Beeinflussung des Antennensystems durch Annäherung eines Objekts

1.3.3 Ansprechempfindlichkeit des Antennensystems beim neuen Sensor

1.3.4 Reduzierung der Antennenmassekapazität $C_{WM}$ beim neuen Sensor

1.3.4.1 Kapazität $C_{WE}$ zwischen Antenne W und Abschirmung E

1.3.4.2 Kapazität $C_{WA}$ zwischen Antenne W und Antennenverstärker AV

1.3.4.3 Kapazität $C_{WT}$ zwischen Antenne W und den vor der Antenne befindlichen, auf Erdpotential M liegenden Teile T

1.4 Beispiele für den Einsatz der Erfindung, anhand von Blockschaltbildern näher erläutert

1.4.1 Der neue Sensor als Distanzmeßgerät zum Messen von Abständen, Durchflußmengen usw.

1.4.2 Der neue Sensor als statischer Annäherungsschalter

1.4.3 Der neue Sensor als dynamischer Annäherungsschalter

1.4.4 Der neue Sensor als Türkantensicherung einseitig bzw. zweiseitig schließender Schiebetüren

1.4.5 Der neue Sensor als Abstandsregler

1.5 Mechanischer und schaltungstechnischer Aufbau der einzelnen Funktionseinheiten der Erfindung

1.5.1 Antennensystem AS mit Antenne W und Antennenverstärker AV

1.5.2 Spitzengleichrichter SG

1.5.3 Symmetrische Additionsstufe SA mit Gleichrichter GR

1.5.4 Schaltpunkteinstellstufe SE mit Nennabstandsvorgabe NA

1.5.5 Nullkorrekturstufe NK

1.5.6 Meßverstärker MV mit Meßgerät MG bei Nennabstand NA als Bezugsgröße

1.5.7 Schaltstufe SS

1.5.9 Netzteil NT

1.5.1o Sinusoszillator SO

2 Patentansprüche aus der Erfindung
3 Zeichnungen zum beschreibenden Text
4 Zusammenfassung der Erfindung

**Ansprüche**
2.
Patentansprüche aus der Erfindung

Die Patentansprüche beziehen sich auf einen kapazitiven Annäherungssensor, der bei seinem Einsatz als Annäherungsschalter die Anwesenheit eines Objekts innerhalb seines über Potentiometer einstellbaren Nennabstandbereichs in ein Schaltsignal umsetzt und der bei seinem Einsatz als Meßwertgeber eine dem Sensor-Objektabstand entsprechende Gleichspannung liefert, die mit vorgegebenem Nennabstand als Bezugsgröße für Meß- bzw. Regelzwecke genutzt werden kann. Er zeichnet sich gegenüber den kapazitiven Annäherungssensoren nach dem herkömmlichen Prinzip durch seine hohe Ansprechempfindlichkeit und durch sein auch bei störenden Umwelteinflüssen und -bedingungen einwandfreies Arbeiten aus und ist dadurch gekennzeichnet:

1. daß die Schwingkreiswechselspannung seines Sinusoszillators, die über einen hochohmigen Antennenwiderstand der Antenne zugeführt wird, mit konstanter Frequenz und Amplitude weit über den positiven bzw. negativen Versorgungsspannungsbereich hinaus schwingt, eine zwingende Notwendigkeit, die erforderlich ist, um die Sensoransprechempfindlichkeit entsprechend der Gleichung

$$\Delta U_W = {{<}\atop{\pm}} \; U \; \frac{C_{WO}}{C_{WM}}$$

(mit $\Delta U_W$, der Amplitude der Antennenwechselspannungsänderung, mit $+U$ der positiven und mit $-U$ der negativen Versorgungsspannung des Netzteils, mit $C_{WO}$, der Antennenobjektkapazität, und mit $C_{WM}$, der Antennenmassekapazität) zu erreichen, wobei

$$U_S \gg {{\pm}} \; U$$

ist ($U_S$ ist die Amplitude der Schwingkreiswechselspannung des Sinusoszillators) und daß aufgrund des stabilen Schwingverhaltens dieses Oszillators eine hohe Konstanz des durch Vergleich des Amplitudengleichspannungsistwertes (Objektabstand) mit dem vorgegebenen Gleichspannungssollwert (Nennabstand) erhaltenen Nutzsignals erreicht wird

2. daß aus schaltungstechnischen Gründen (zur Einsparung eines zweiten Versorgungsnetzteils) die Schwingkreiswechselspannung seines Sinusoszillators nicht vom Schwingkreisausgang aus, sondern bei (geerdetem, d.h.,) auf Masse liegendem Schwingkreisausgang vom Nullpotential des Versorgungsnetzteils (dem Fußpunkt des Schwingkreises) aus über den Antennenwiderstand der Antenne zugeführt wird, wobei das Nullpotential des Netzteils, jetzt über die Schwingkreisinduktivität mit Masse verbunden, kein festes Potential mehr besitzt, sondern mit der Schwingkreisfrequenz und -amplitude bezüglich Massepotential schwingt

3. daß seine Antenne, im allgemeinen als Flächenantenne ausgebildet, durch die Antennemassekapazität bereits vorbelastet ist und damit bei Wahl der entsprechenden Antennenwiderstandsgröße der größte Teil der Schwingkreiswechselspannung über dieser Antennenmassekapazität abfällt und nur der am Antennenwiderstand verbleibende Rest dieser Schwingkreiswechselspannung, dessen Größe sich bei Erreichen des vorgegebenen Nennabstands durch das sich nähernde Objekt innerhalb des Gleichspannungsbereichs ±U des Versorgungsnetzteils befindet, zur Weiterverarbeitung für Schalt-, Meß-bzw. Regelzwecke genutzt wird, wobei dem Antennenwiderstand hierbei drei Funktionen zufallen:

a. Er bewirkt die Arbeitspunkteinstellung des Antennenverstärkers (Operationsverstärkers)

b. Er ist Teilwiderstand des parallel zum Parallelschwingkreis des Sinusoszillators geschalteten Spannungsteilers, der aus diesem Widerstand und dem durch Parallelschaltung von Antennenmasse- und Antennenobjektkapazität gebildeten kapazitiven Widerstand besteht

c. Er führt den über ihm abfallenden Teil der Schwingkreiswechselspannung auf den Eingang des Antennenverstärkers und ist damit Eingangswiderstand dieses Verstärkers

4. daß seine Flächenantenne in einen vorne offenen Abschirmbecher eingelassen ist, der durch das ihm aufgeprägte Antennenwechselspannungspotential diese Antenne weitgehend gegenüber seitlich von ihr befindliche, auf Massepotential liegende Teile abschirmt, d.h., die Antennenmassekapazität bis auf einen geringen Restbetrag reduziert, und daß dieser Abschirmbecher zur Veränderung der Wahrnehmungszone, d.h., zur Formung des vor der Antenne befindlichen elektromagnetischen Feldes, mit einer verstellbaren Abschirmblende versehen werden kann

5. daß der zwischen Antenne und Abschirmbecher bestehende Potentialunterschied, verursacht durch die Belastung des Antennenverstärkerausgangs mit den zwischen Abschirmbecher und Masse fließenden Ladestrom, zur Reduzierung der Antennenmassekapazität über eine geringfügige Spannungsverstärkung des Antennenverstärkers ausgeglichen wird, daß durch leichte Überkompensation, d.h., durch geringfügiges weiteres Anheben der Abschirmbecherwechselspannung über die Antennenwechselspannung hinaus (mit entgegengesetzt gerichtetem, zwischen Antenne und Abschirmung fließenden Ladestrom), eine Steigerung seiner Ansprechempfindlichkeit erreicht wird und daß darüber hinaus sämtliche in den Abschirmbecher hineinragenden Teile dieses Antennenverstärkers zur Vermeidung von Masseeinwirkungen dieser Teile auf die Antenne (d.h., zu einer weiteren Reduzierung der Antennenmassekapazität) ebenfalls die Antennenverstärkerausgangsspannung aufgeprägt erhalten

6. daß die Ausgangswechselspannung seines Antennenverstärkers einem Amplituden-Spitzengleichrichter zugeleitet wird, d.h., daß beim folgenden Soll-Istwertvergleich - (Schaltpunkteinstellung) als Istwert nicht der Gleichspannungsmittelwert, sondern zur Erhöhung der Ansprechempfindlichkeit des Sensors der Amplitudengleichspannungswert für den Vergleich mit dem vorgegebenen Gleichspannungssollwert (Nennabstand) herangezogen wird und daß damit auch bei eingestelltem großen Nennabstand infolge dieser hohen Ansprechempfindlichkeit nur eine geringe Schalthysterese besteht

7. daß bei seinem Einsatz als Annäherungsschalter zur Einstellung seines in weiten Grenzen wählbaren Nennabstands (Schaltabstands) nur ein Potentiometer (einzigster vorzunehmender Abgleich des Annäherungsschalters) erforderlich ist

8. daß bei seinem Einsatz als Türkantensicherung (eine Art Annäherungsschalter) für einseitig bzw. doppelseitig - schließende Schiebetüren zwei Antennensysteme erforderlich sind, denen die Schwingkreiswechselspannung vom Sinusoszillator aus jeweils über getrennte, gleich große Antennenwiderstände zuge führt wird und deren Ausgangsspannung nach erfolgter Amplitudenspitzengleichrichtung mit entgegengesetzter Polarität, symmetrischer Addition und nochmaliger Gleichrichtung als Summenspannung für den Vergleich mit dem vorgegebenen Gleichspannungssollwert, der dem gewünschten Nennabstand entspricht, zur Verfügung steht und daß zum Abgleich dieser beiden Antennensysteme nur zwei Potentiometer benötigt werden:

a. Potentiometer 1 zur Symmetrierung, d.h., zur Abstimmung beider Antennensysteme auf den gleichen Schaltabstand

b. Potentiometer 2 zur Nennabstandseinstellung, d.h., zur Einstellung des für beide Antennensysteme gleichen Schaltabstands

9. daß bei seinem Einsatz als Türkantensicherung die Abschirmbecher der Antennensysteme als Abschirmrinnen ausgebildet sind, in die als Antenne mittig (über die gesamte Rinnenlänge hinweg) ein Antennendraht angeordnet ist, dessen Länge zur Verringerung der Antennenmassekapazität (Kapazität zwischen Antenne und Türsturz und zwischen Antenne und Bodenfläche) beidseitig gekürzt ist - (gute Anpassungsfähigkeit des Antennensystems an die jeweilige Aufgabenstellung) und daß die beim Schließen der Schiebetüren zunehmende Abschirmwirkung, die eine Verringerung der Antennenmassekapazität, der Antennenwechselspannung und damit des Sensor-Schaltabstands bedeutet, durch eine entsprechende, künstlich erzeugte Masseeinwirkung oder durch eine Korrektur der Nennabstandsvorgabe in Abhängigkeit vom Schließweg der Schiebetüren - (sofern erforderlich) ausgeglichen werden kann

10. daß bei Auslegung seiner elektronischen Schaltung als integrierter Schaltkreis (bei Aufteilung der elektronischen Schaltung in zwei ICs, wobei der erste IC sämtliche Teile des Antennenverstärkers mit aufgeprägtem Antennenwechselspannungspotential enthält) aufgrund der damit verbundenen geringen Gestehungskosten der Einsatz dieses Sensors im großen Umfang möglich ist

3. _Zeichnungen_   Die zum beschreibenden Text gehörenden Bilder, durchnummeriert von 1 bis 37

Funktionsschema 1

$U_W$ = Antennenausgangs-spannung bei Null-potential N des Netzteils auf Masse M

Bild 1

Prinzipschaltbild 1

Bild 2

Funktionsschema 2

$U_W$ = Antennenausgangs-spannung bei Nullpo-tenfial N des Netzteils auf Masse M

Bild 3

Prinzipschaltbild 2

Bild 4

Funktionsschema 3

$U_W$ = Antennenausgangsspannung bei Schwingkreisausgang S
auf Masse M

Bild 5

$U_{WE} \sin wt$

$I_{WE} \cos wt$

Bild 8

Prinzipschaltbild 3

$C_{WM}$

Bild 6

$U_E = U_W$

Bild 7

Bild 9

0 191 137

Bild 10

Bild 11

Bild 12

Bild 13

Bild 14

Bild 15

0 191 137

R = R1 + R2

**Bild 16**

R = R1 + R2

**Bild 17**

Bild 19

Bild 20

E=Abschirmrinne

W= Antennendraht

Bild 22

Bild 23

Bild 21

0 191 137

AV = Antennenverstärker
B  = verstellbare Abschirmblende
E  = Abschirmbecher
K  = Kabel
L  = Verbindungsdrähte
SG = Schaltgerät
W  = hinter Leiterplatte angeordnete Flächenantenne

Bild 24

Bild 25

Bild 26

Bild 27

$x_W = x - w$

Bild 35

$R = R1 + R2$

Bild 28

Bild 29

$$R_{A2} = \frac{R_{A1}}{2}$$

$$R_A = R_E$$

$$R_{E2} = \frac{R_{E1}}{2}$$

Bild 30

Bild 31

Bild 32

Bild 33

Bild 37

Bild 34

Bild 36